# EUROPEAN PATENT APPLICATION

(11) **EP 3 689 499 A1**
(43) Date of publication of application: **05.08.2020**
(21) Application number: 20153960.8
(22) Date of filing: 27.01.2020
(51) Int. Cl.: B22F 1/02, B22F 3/105, B22F 5/00, B33Y 10/00, B33Y 70/00, C22C 1/04

(54) **MANUFACTURING OF HIGH TEMPERATURE ALUMINUM COMPONENTS VIA COATING OF BASE POWDER**

(30) Priority: 30.01.2019 US 201962798640 P; 14.01.2020 US 202016741920
(71) Applicant: Honeywell International Inc., Morris Plains, NJ 07950 (US)
(72) Inventor: GODFREY, Donald, Morris Plains, NJ New Jersey 07950 (US); MADER, Morgan, Morris Plains, NJ New Jersey 07950 (US); MARSHALL, Ryan, Morris Plains, NJ New Jersey 07950 (US)
(74) Representative: LKGlobal UK Ltd.

(57) **Abstract**

A method for manufacturing an article, including: providing a three-dimensional computer model of the article; providing a Al-Fe-V-Si metal alloy in powdered form comprising a plurality of powder particles; coating the plurality of powder particles with a coating of silicon using a chemical vapor deposition process; at a powder bed additive manufacturing apparatus, supplying the coated metal alloy and loading the three-dimensional model; and using the powder bed additive manufacturing apparatus, manufacturing the article in accordance with the loaded three-dimensional model in a layer-by-layer manner with the supplied coated metal alloy.

## Description

### TECHNICAL FIELD

The present disclosure generally relates to methods of manufacturing components using metal alloys. More particularly, the present disclosure relates to additively manufactured turbine components with aluminum-iron-vanadium-silicon alloys utilizing a powder coating process.

### BACKGROUND

In the context of gas turbine engines, the need for lighter weight components and higher gas turbine engine operating temperatures has created a need for aluminum to replace steels and titanium in the 250 °F to 600 °F mid-temperature operating range. Aluminum-iron-vanadium-silicon alloys, such as aluminum alloy 8009 (Al-8009), have been shown to be capable of operating at up to 600 °F and able to withstand excursions up to 800 °F. Accordingly, Al-8009 and similar alloys could be substituted for titanium in the main and trim bleed valves in gas turbine engines, which would result in a considerable cost and weight reduction.

Accordingly, it is desirable to provide improved methods for manufacturing components from Al-Fe-V-Si alloys. Furthermore, other desirable features and characteristics of the present invention will become apparent from the subsequent detailed description and the appended claims, taken in conjunction with the accompanying drawings.

### BRIEF SUMMARY

According to various embodiments, disclosed is a method for manufacturing an article, including: providing a three-dimensional computer model of the article; providing a Al-Fe-V-Si metal alloy in powdered form comprising a plurality of powder particles; coating the plurality of powder particles with a coating of silicon using a chemical vapor deposition process; at a powder bed additive manufacturing apparatus, supplying the coated metal alloy and loading the three-dimensional model; and using the powder bed additive manufacturing apparatus, manufacturing the article in accordance with the loaded three-dimensional model in a layer-by-layer manner with the supplied coated metal alloy.

This summary is provided to introduce a selection of concepts in a simplified form that are further described below in the detailed description. This summary is not intended to identify key features or essential features of the claimed subject matter, nor is it intended to be used as an aid in determining the scope of the claimed subject matter.

### DESCRIPTION OF THE DRAWINGS

The exemplary embodiments will hereinafter be described in conjunction with the following drawing figures, wherein like numerals denote like elements, and wherein:
FIG. 1A illustrates a prior art planar flow casting (PFC) type melt spin casting (MSC) process, which has previously been used in the manufacture of Al-Fe-V-Si alloy components;
FIG. 1B is a flow diagram illustrating the steps in a prior art process for forming components with dispersion-strengthened aluminum alloys, such as Al-Fe-V-Si alloys;
FIG. 2 is a flow diagram illustrating steps in a method of forming an Al-Fe-V-Si alloy component in accordance with the present disclosure;
FIG. 3 is an exemplary powder bed additive manufacturing system suitable for use in forming an Al-Fe-V-Si alloy component in accordance with the present disclosure;
FIG. 4 is a generalized illustration of the process of chemical vapor deposition (CVD);
FIG. 5A shows an exemplary powder particle prior to the CVD process;
FIG. 5B hypothesizes an uncoated powder arrangement in the powder bed additive manufacturing system prior to the CVD process;
FIG. 6A shows an exemplary coated powder particle after the CVD process;
FIG. 6B hypothesizes a coated powder arrangement in the powder bed additive manufacturing system after the CVD process; and
FIG. 7 is a flowchart illustrating an exemplary process for manufacturing an article in accordance with some embodiments of the present disclosure.

### DETAILED DESCRIPTION

The following detailed description is merely exemplary in nature and is not intended to limit the inventive subject matter or the application and uses of the inventive subject matter. Furthermore, there is no intention to be bound by any theory presented in the preceding background or the following detailed description.

### Introduction

Al-Fe-V-Si alloy components require a multi-step process that includes rapid solidification ribbon casting, ribbon pulverizing, powder canning, hot isostatic pressing (HIP), extrusion, and forging to generate and maintain its unique microstructure and material properties. It has been found that the need for extensive hot working by extrusion and forging also limits the size and complexity of parts that can be practicably produced from the alloy.

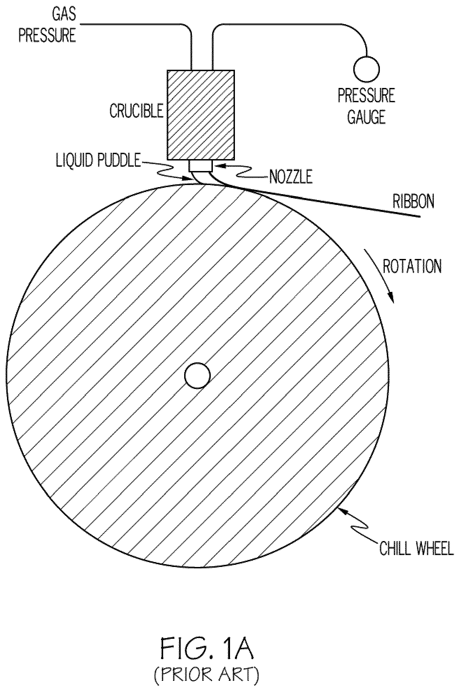

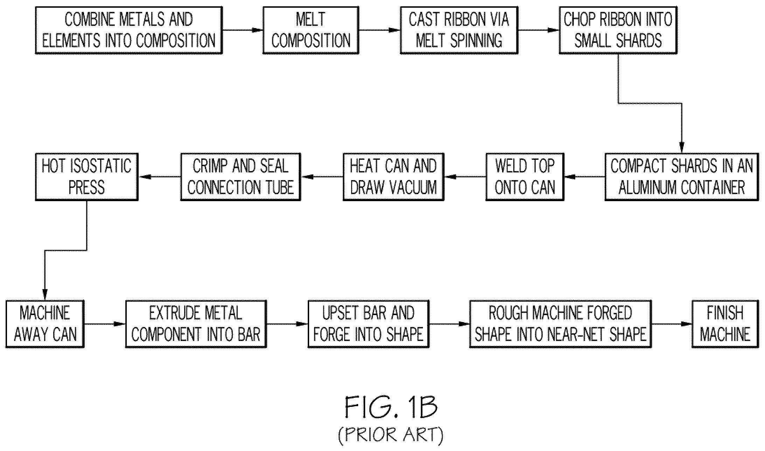

It has been observed that melt spinning has been the only practical means of producing solidification cooling rates high enough, ∼10⁶ °F/second, to form the desired microstructure in this material. Melt spinning processes produce thin (∼0.001") alloy ribbons by impinging a molten metal stream onto a rapidly spinning, water cooled wheel, as illustrated in FIG. 1A (showing a planar flow casting (PFC) type melt spinning process). In order to produce useful products, the alloy ribbons must be broken up and then consolidated and shaped using powder processing processes such as hot isostatic pressing, extrusion, and forging, as illustrated in FIG. 1B.

When the Al-Fe-V-Si alloy is melt spun, the rapid solidification produces enhanced solubility of iron, vanadium, and silicon, and allows for the formation of a very fine dispersion of Al(Fe,V) silicides, which is a very effective strengthening mechanism. However, it has been observed that the production of useful components from the rapidly solidified ribbons or flakes involves a series of manufacturing process steps that are time consuming and expensive (see FIG. 1B).

In order to avoid these steps, one prior art approach uses additive manufacturing processes, such as direct metal laser sintering (DMLS) or electron beam melting (EBM), which can be used to produce components directly from atomized Al-Fe-V-Si alloy powder. The DMLS process may allow for the elimination of several expensive manufacturing processes associated with producing parts from MS ribbons, in addition to having more design freedom. The rapid cooling of the Al-Fe-V-Si alloy via the DMLS process has been thought to allow for the manufacturing of components directly from the alloy powder material, built up by using a scanning laser to melt and solidify very thin (less than 0.001") layers of powder. The cooling rates achieved by utilizing this technology are as high as 10⁷ °F/second (depending upon build geometry, laser focal parameters, laser power and laser scanning speed), thus in theory producing the desired microstructure directly in the part without the costs and complexities of the MCS processing. However, in some scenarios, has been found that using DMSL technology in this context introduces remelting of the previously atomized powder and thus puts the optimal rapidly solidified microstructure at theoretical risk of non-uniform solidification rates based on part cross section geometry. In order to avoid the aforesaid remelting that may occur when using DMLS, the present disclosure utilizes a novel powder coating process before loading the powder into the DMLS machine, as will be described in greater detail below.

### Al-Fe-V-Si Alloy

Exemplary methods for manufacturing an article include providing a metal alloy in powdered form. The metal alloy is an aluminum-iron-vanadium-silicon alloy. Al-Fe-V-Si alloys contain a uniform dispersion of stable (up to about 350 °C), nanometer scale silicides with a composition of about Al₁₂(Fe,V)₃Si in an aluminum solid solution matrix. Al-Fe-V-Si alloys have been developed that have mechanical properties comparable to titanium alloys up to temperatures of around 350 °C and can, because of their lower density - 2.9 compared to 4.5g/cm³ - result in significant weight savings in several gas turbine engine applications.

Alloys suitable for use in the process of the present disclosure are the rapidly solidified high-temperature aluminum alloys disclosed in US 4,729,790, US 4,828,632, and US 4,878,967. Such alloys have a composition of the formula Al_{bal}FeₐSi_{b}X_{c}, wherein X is at least one element selected from the group consisting of Mn, V, Cr, Mo, W, Nb, Ta; "a" ranges from 2.0 to 7.5 at% (atomic percent); "b" ranges from 0.5 to 3.0 at%; "c" ranges from 0.05 to 3.5 at%, and the balance is aluminum plus incidental impurities, with the proviso that the ratio [Fe + X]: Si is within the range from about 2.0:1 to 5.0:1.

The alloys used in this disclosure are preferably based on Al-Fe-V-Si. The Al-Fe-V-Si alloy in accordance with the present disclosure may be the Al-8009 alloy. Accordingly, Al-Fe-V-Si alloys that may be used in accordance with the present disclosure may be characterized by the following composition (TABLE 1), in weight-%:

**TABLE 1**

| Element | Min. Content | Max. Content |
|---|---|---|
| Aluminum | 86 | 89 |
| Iron | 8.4 | 8.9 |
| Silicon | 1.6 | 1.9 |
| Vanadium | 1.1 | 1.5 |
| Oxygen | 0 | 0.16 |
| Zinc | 0 | 0.25 |
| Titanium | 0 | 0.10 |
| Chromium | 0 | 0.10 |
| Manganese | 0 | 0.10 |
| Other (B, P, S, C) (each) | 0 | 0.05 |

Al-Fe-V-Si alloys in accordance with other embodiments of the present disclosure may be characterized by the following composition (TABLE 2), in weight-%:

**TABLE 2**

| Element | Min. Content | Max. Content |
|---|---|---|
| Aluminum | 87 | 88 |
| Iron | 8.5 | 8.8 |
| Silicon | 1.7 | 1.9 |
| Vanadium | 1.2 | 1.4 |
| Oxygen | 0 | 0.16 |
| Zinc | 0 | 0.25 |
| Titanium | 0 | 0.10 |
| Chromium | 0 | 0.10 |
| Manganese | 0 | 0.10 |
| Other (B, P, S, C) (each) | 0 | 0.05 |

The powdered form of the Al-Fe-V-Si alloy is produced by combining the various constituents (metals and other elements) of the alloy into a mixture, melting the mixture, and atomizing the melted mixture to form a powder, a process which is well-known in the art. The atomization process is performed due to the fact that it is capable of producing substantially spherical grains of the powder - as is well-known in the art, due to the nature of AM processes when the powder is "swept" onto the bed in thin layers, it is desirable to have particles that are as spherical as possible for consistency in the thickness of the new layer on the bed. The powdered form suitable for use in accordance with embodiments of the present disclosure may be characterized by a grain size range of about 5 to about 22 microns and a d50 grain size average of about 10 to about 13 microns, such as a grain size of about 10 to about 17 microns and a d50 grain size average of about 11 to about 12 microns. (As is conventional in the art, sizes herein are measure assuming spherical grains.) Powders that are characterized by this relatively small in grain size enable finer detail in the finished printed component. A powder coating process is also employed, as will be described in greater detail below, subsequent to making the powder as described herein. The powder coating process will be described after the following powder-bad additive manufacturing process description.

### Powder-Bed Additive Manufacturing Process

Using a novel powder-bed additive manufacturing (PBAM) approach (such as DMLS), it is now possible to create a manufacturing process to produce near-net shape components directly from ceramic strengthened powders that, until now, could only be produced using the prior art more expensive methods. PBAM is a manufacturing process that allows for the manufacturing of components layer-by-layer. The PBAM process allows for the elimination of expensive manufacturing processes associated with producing parts from press and sinter methods. The laser melting and subsequent rapid cooling of alloy powders to produce an alloy via PBAM is a unique process to produce components even with intricate internal passages that are not possible using the prior art technologies. PBAM enables the manufacturing of components directly from pre-alloyed powders built by using a scanning laser to melt and solidify very thin (less than 0.001") layers of powder. The cooling rates achieved by utilizing this technology are as high as 10⁷ °F/second (depending upon build geometry, laser focal parameters, laser power and laser scanning speed) thus producing the desired microstructure directly in the part without the costs and complexities of prior art processing steps.

Greater detail is now provided regarding the powder bed additive manufacturing techniques that may be used in connection with the above-described pre-alloy powders, and that achieve the aforementioned essential features of the present disclosure. Suitable powder bed additive manufacturing processes use a small, focused beam to build a component by fusing one layer of powder to the layer of powder directly beneath it, thus using the underlying previously solidified layers as a heat sink to achieve high cooling rates in the currently deposited and melted layer. The heat input for the process is controlled with laser focal parameters, laser power, and laser scanning speed. The rapid solidification rate is controlled by the conduction from the currently melted layer to the underlying previously solidified layers. Thus, powder bed temperature, support structures, and PBAM build foundation are all designed and controlled to provide the necessary heat sink parameters to achieve the appropriate microstructure. The PBAM process enables parts to be formed to near-net where appropriate, which eliminates expensive machining costs associated with prior art processes.

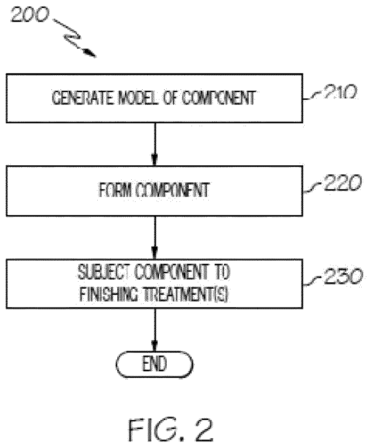

FIG. 2 is a flowchart illustrating a method 200 for manufacturing a component, for example an aerospace or gas turbine engine component, using a coated Al-Fe-V-Si alloy powder in accordance with an exemplary embodiment using, in whole or in part, powder bed additive manufacturing techniques based on low energy density energy beams. In a first step 210, a model, such as a design model, of the component may be defined in any suitable manner. For example, the model may be designed with computer aided design (CAD) software and may include three-dimensional ("3D") numeric coordinates of the entire configuration of the component including both external and internal surfaces. In one exemplary embodiment, the model may include a number of successive two-dimensional ("2D") cross-sectional slices that together form the 3D component. Of course, it is not necessary that a "near-net" component be formed using this process. Rather, it may simply be desired to produce a "block" of the Al-Fe-V-Si alloy using PBAM. Accordingly, the present disclosure should not be considered as limited by any particular component design.

In step 220 of the method 200, the component is formed according to the model of step 210. In one exemplary embodiment, a portion of the component is formed using a rapid prototyping or additive layer manufacturing process. In other embodiments, the entire component is formed using a rapid prototyping or additive layer manufacturing process. Although additive layer manufacturing processes are described in greater detail below, in still other alternative embodiments, portions of the component may be forged or cast in step 220.

Some examples of additive layer manufacturing processes include: selective laser sintering in which a laser is used to sinter a powder media in precisely controlled locations; laser wire deposition in which a wire feedstock is melted by a laser and then deposited and solidified in precise locations to build the product; electron beam melting; laser engineered net shaping; and selective laser melting. In general, powder bed additive manufacturing techniques provide flexibility in free-form fabrication without geometric constraints, fast material processing time, and innovative joining techniques. In one particular exemplary embodiment, PBAM is used to produce the component in step 220. PBAM is a commercially available laser-based rapid prototyping and tooling process by which complex parts may be directly produced by precision melting and solidification of metal powder into successive layers of larger structures, each layer corresponding to a cross-sectional layer of the 3D component.

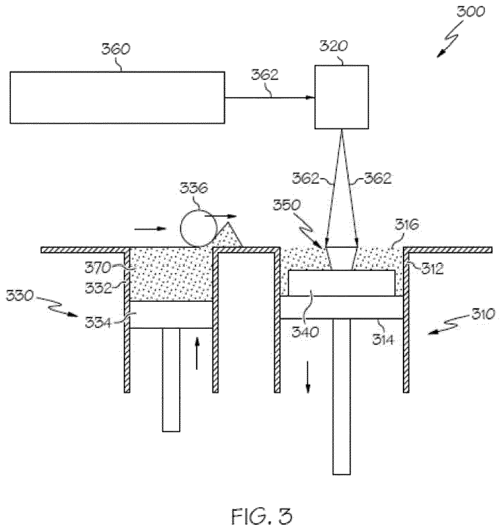

As such, in one exemplary embodiment, step 220 is performed with PBAM techniques to form the component. However, prior to a discussion of the subsequent method steps, reference is made to FIG. 3, which is a schematic view of a PBAM system 300 for manufacturing the component, for example one or more gas turbine engine components, in accordance with an exemplary embodiment.

Referring to FIG. 3, the system 300 includes a fabrication device 310, a powder delivery device 330, a scanner 320, and a low energy density energy beam generator, such as a laser 360 (or an electron beam generator in other embodiments) that function to manufacture the article 350 (e.g., the component) with build material 370. The fabrication device 310 includes a build container 312 with a fabrication support 314 on which the article 350 is formed and supported. The fabrication support 314 is movable within the build container 312 in a vertical direction and is adjusted in such a way to define a working plane 316. The delivery device 330 includes a powder chamber 332 with a delivery support 334 that supports the build material 370 and is also movable in the vertical direction. The delivery device 330 further includes a roller or wiper 336 that transfers build material 370 from the delivery device 330 to the fabrication device 310.

During operation, a base block 340 may be installed on the fabrication support 314. The fabrication support 314 is lowered and the delivery support 334 is raised. The roller or wiper 336 scrapes or otherwise pushes a portion of the coated-powder build material 370 from the delivery device 330 to form the working plane 316 in the fabrication device 310. The laser 360 emits a laser beam 362, which is directed by the scanner 320 onto the build material 370 in the working plane 316 to selectively fuse the build material 370 into a cross-sectional layer of the article 350 according to the design. More specifically, the speed, position, and other operating parameters of the laser beam 362 are controlled to selectively fuse the coated-powder of the build material 370 into larger structures by rapidly melting the powder particles that may melt or diffuse into the solid structure below, and subsequently, cool and re-solidify. As such, based on the control of the laser beam 362, each layer of build material 370 may include unfused and fused build material 370 that respectively corresponds to the cross-sectional passages and walls that form the article 350. In general, the laser beam 362 is relatively low power to selectively fuse the individual layer of build material 370. As an example, the laser beam 362 may have a power of approximately 50 to 500 Watts, although any suitable power may be provided.

Upon completion of a respective layer, the fabrication support 314 is lowered and the delivery support 334 is raised. Typically, the fabrication support 314, and thus the article 350, does not move in a horizontal plane during this step. The roller or wiper 336 again pushes a portion of the coated-powder build material 370 from the delivery device 330 to form an additional layer of build material 370 on the working plane 316 of the fabrication device 310. The laser beam 362 is movably supported relative to the article 350 and is again controlled to selectively form another cross-sectional layer. As such, the article 350 is positioned in a bed of build material 370 as the successive layers are formed such that the unfused and fused material supports subsequent layers. This process is continued according to the modeled design as successive cross-sectional layers are formed into the completed desired portion, e.g., the component of step 220.

The delivery of coated-powder build material 370 and movement of the article 350 in the vertical direction are relatively constant and only the movement of the laser beam 362 is selectively controlled to provide a simpler and more precise implementation. The localized fusing of the build material 370 enables more precise placement of fused material to reduce or eliminate the occurrence of over-deposition of material and excessive energy or heat, which may otherwise result in cracking or distortion. The unused and unfused build material 370 may be reused, thereby further reducing scrap.

Any suitable laser and laser parameters may be used, including considerations with respect to power, laser beam spot size, and scanning velocity. The build material 370 is provided as an Al-Fe-V-Si alloy in a pre-alloy coated-powder form, as described below. In general, the coated-powder build material 370 may be selected for enhanced strength, durability, and useful life, particularly at high temperatures, although as described below, the powder build material 370 may also be selected based on the intended function of the area being formed. The coated-powder form of the alloy is produced by combining the various constituents (metals and other elements) of the alloy into a mixture, melting the mixture, and atomizing the melted mixture to form a powder, a process which is well-known in the art, and thereafter coating using chemical vapor deposition, as will be described below.

Returning to FIG. 2, at the completion of step 220, the article, i.e., the component, may be given a stress relief treatment and then is removed from the powder bed additive manufacturing system (e.g., from the PBAM system 300). In optional step 230, the component formed in step 220 may undergo finishing treatments. Finishing treatments may include, for example, polishing and/or the application of coatings. If necessary, the component may be machined to final specifications. For example, in some embodiments in accordance with the present disclosure, aerospace components can be manufactured by the PBAM process (optionally including machining) described herein.

### Powder Coating Process

Great potential exists for powder bed additive Manufacturing (PBAM) to produce components using alloys that have a high predictability to cracking due to the chemistry of the powder. To prevent the procurement of an expensive heat of material that would later be forged into wire or bar for atomization, chemical vapor deposition (CVD) can be used to encapsulate the Al-Fe-V-Si material with a more weld friendly alloy. CVD is a process that has the advantage of forming a new alloy mixture by coating powder after it (the powder) has been atomization.

The present disclosure overcomes the deficiencies in the prior art by introducing a process that coats the Al-Fe-V-Si powder in silicon. This addition increases the silicon content to approximately 2.5 wt% (such as about 2.2% to about 2.8%, about 2.3% to about 2.7%, or about 2.4% to about 2.6%), providing a solidification range and improving fluidity, increasing the weldability of the alloy.

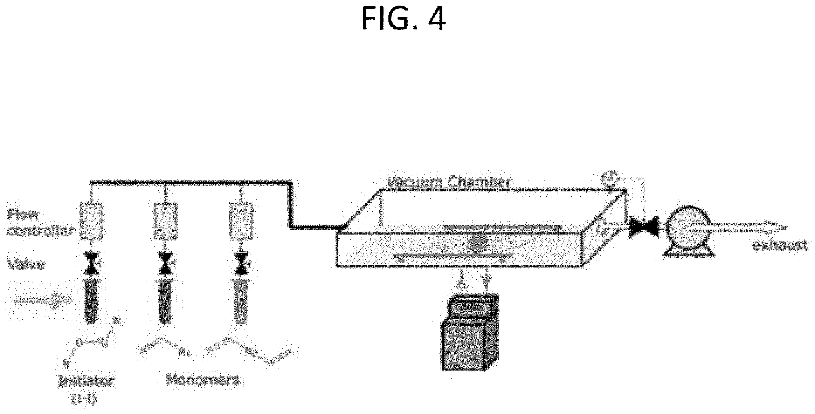

In CVD, the base powder is exposed to one or more volatile precursors, which react and/or decompose on the powder surface to produce the desired deposit. Volatile byproducts are also produced, which are removed by gas flow through the reaction chamber. Silicon may be deposited using precursors such as trichlorosilane or silane. FIG. 4 is a generalized depiction of the CVD process.

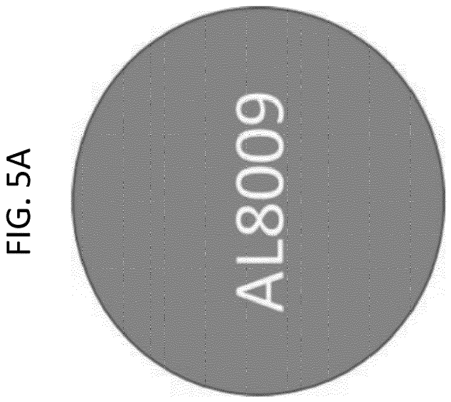

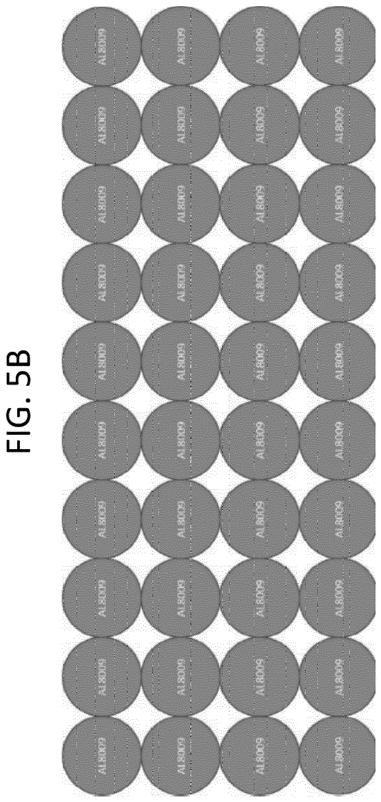

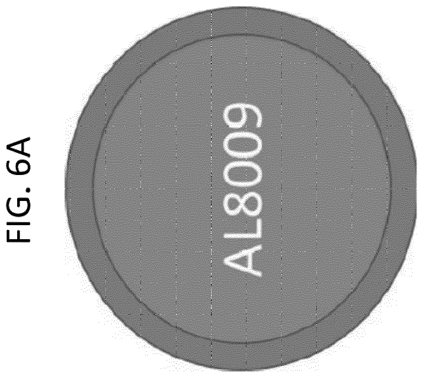

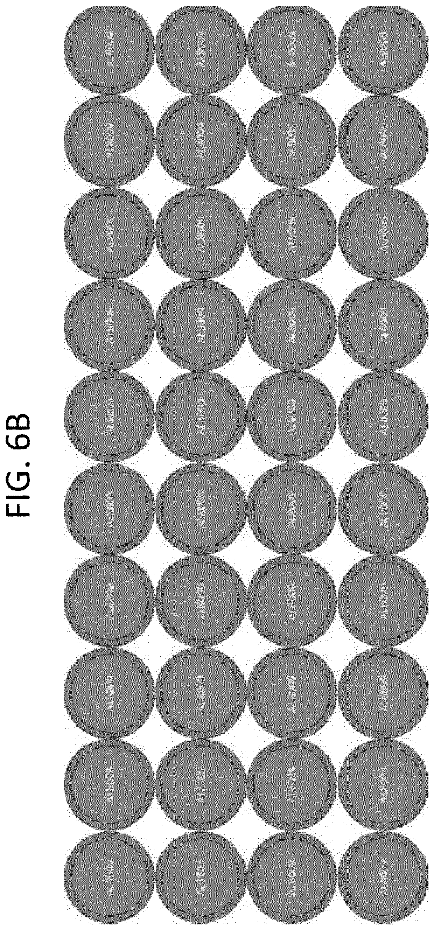

FIG. 5A shows an exemplary powder particle prior to the CVD process. FIG. 5B hypothesizes an uncoated powder arrangement in the powder bed additive manufacturing system prior to the CVD process. FIG. 6A shows an exemplary coated powder particle after the CVD process. Furthermore, FIG. 6B hypothesizes a coated powder arrangement in the powder bed additive manufacturing system after the CVD process. The coating material applied during the CVD process will coat the powder from about 5% to about 10% in thickness with respect to its original diameter, all around the particle. This coating will result in an increase in size in diameter of from about 1.5 to about 3 microns.

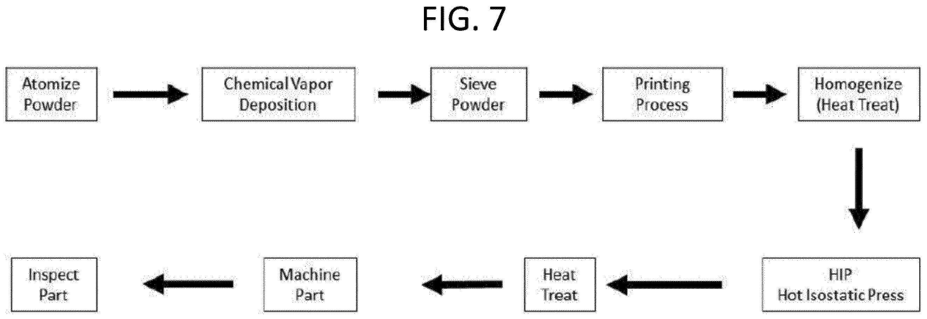

FIG. 7 is a flowchart illustrating an exemplary process for manufacturing an article in accordance with some embodiments of the present disclosure. The process steps, in sequence, generally include atomizing the powder, chemical vapor deposition to coat the powder, sieving the powder, the printing process, homogenization (heat treatment), hot isostatic pressing, further heat treating, machining of the part, and inspection of the part. With respect to various embodiments: some of these steps may be performed in a different sequence; some of the steps may be repeated; some of the steps may be eliminated; addition steps may be employed.

Accordingly, the present disclosure has provided methods that utilize CVD to coat Al-Fe-V-Si powder particles with a coating of silicon, prior to being used in an additive manufacturing process to manufacture an article, such as a turbine engine component. Furthermore, the present disclosure has provided methods that enable parts to be formed closer to near-net where appropriate, which eliminates expensive machining costs associated with prior art post-build processes.

While at least one exemplary embodiment has been presented in the foregoing detailed description, it should be appreciated that a vast number of variations exist. It should also be appreciated that the exemplary embodiment or exemplary embodiments are only examples, and are not intended to limit the scope, applicability, or configuration of the disclosure in any way. Rather, the foregoing detailed description will provide those skilled in the art with a convenient road map for implementing the exemplary embodiment or exemplary embodiments. It should be understood that various changes can be made in the function and arrangement of elements without departing from the scope of the disclosure as set forth in the appended claims and the legal equivalents thereof.

## Claims

1. A method for manufacturing an article, comprising:
providing a three-dimensional computer model of the article;
providing a Al-Fe-V-Si metal alloy in powdered form comprising a plurality of powder particles;
coating the plurality of powder particles with a coating of silicon using a chemical vapor deposition process;
at a powder bed additive manufacturing apparatus, supplying the coated metal alloy and loading the three-dimensional model; and
using the powder bed additive manufacturing apparatus, manufacturing the article in accordance with the loaded three-dimensional model in a layer-by-layer manner with the supplied coated metal alloy.

2. The method of claim 1, wherein the Al-Fe-V-Si metal alloy comprises: AL-8009 metal alloy.

3. The method of claim 1, wherein the article comprises a gas turbine engine component.

4. The method of claim 3, wherein the gas turbine engine component is selected from the group consisting of: main and trim bleed valves.

5. The method of claim 1, wherein the powder particles are **characterized by** a grain size range of about 5 to about 22 microns and a d50 grain size average of about 10 to about 13 microns.

6. The method of claim 5, wherein the powder particles are **characterized by** a grain size of about 10 to about 17 microns and a d50 grain size average of about 11 to about 12 microns.

7. The method of claim 1, wherein the step of coating the plurality of powder particles increases a Si content of the Al-Fe-V-Si metal alloy to from about 2.2 wt.-% to about 2.8 wt.-%.

8. The method of claim 7, wherein the step of coating the plurality of powder particles increases a Si content of the Al-Fe-V-Si metal alloy to from about 2.4 wt.-% to about 2.6 wt.-%.

9. The method of claim 1, wherein the step of coating the plurality of powder particles coats the powder particles from about 5% to about 10% in thickness with respect to their original diameter, all around the powder particles.

10. The method of claim 1, further comprising hot isostatic pressing (HIP) the article subsequent to the step of manufacturing the article.
